# EUROPEAN PATENT SPECIFICATION

(11) **EP 2 736 066 B1**
(45) Date of publication and mention of the grant of the patent: **15.08.2018**
(21) Application number: 12817539.5
(22) Date of filing: 19.07.2012
(51) Int. Cl.: G03F 7/00, G03F 7/40, H01L 21/027, B82Y 40/00, B82Y 10/00

(54) **METHOD FOR MANUFACTURING A SUPERHYDROPHOBIC FILM SHEET**
VERFAHREN ZUR HERSTELLUNG EINER SUPERHYDROPHOBEN FOLIENBAHN
PROCÉDÉ DE FABRICATION DE FEUILLE DE FILM SUPERHYDROPHOBE

(30) Priority: 22.07.2011 KR 20110072945
(43) Date of publication of application: 28.05.2014
(73) Proprietor: Industry Foundation Of Chonnam National University, Gwangju 500-757 (KR)
(72) Inventor: LEE, Dong Weon, Gwangju 500-070 (KR); GO, Gun, Mokpo-si, Jeollanam-do 530-751 (KR); PARK, Seung Hwan, Gwangju 500-170 (KR); LEE, Sa Myung, Gwangju 500-040 (KR); PARK, Jong Sung, Gwangju 500-826 (KR)
(74) Representative: Kransell & Wennborg KB
(86) International application number: PCT/KR2012/005774
(87) International publication number: WO 2013/015562

(56) References cited:
- WO-A1-2010/138132
- WO-A2-2012/087352
- CN-A- 101 157 767
- CN-A- 101 537 682
- JP-A- 2005 262 522
- KR-A- 20100 008 579
- KR-A- 20100 037 717
- US-A1- 2007 231 542
- US-A1- 2008 318 170
- XUE-MEI LI ET AL: "What do we need for a superhydrophobic surface? A review on the recent progress in the preparation of superhydrophobic surfaces", CHEMICAL SOCIETY REVIEWS, CHEMICAL SOCIETY, LONDON, GB, vol. 36, no. 8, 1 January 2007 (2007-01-01), pages 1350-1368, XP002667653, ISSN: 0306-0012, DOI: 10.1039/B602486F [retrieved on 2007-01-31]
- JUNG, SUN NYEONG ET AL. FABRICATION OF WATER STRIDER ROBOT USING SUPER HYDROPHOBIC SURFACES WITH MICRO PROTRUSIONS February 2008, PUSAN UNIVERSITY GRADUATE SCHOOL, XP008173353

## Description

### Technical Field

The invention relates to the method for fabricating super-hydrophobic film sheet, more specifically the method for fabricating super-hydrophobic film sheet with a super-hydrophobic surface comprising creating a structure with protrusion having super-hydrophobic effect like a lotus leaf and coating on it PDMS which is polymer of optically transparent material with hydrophobic property.

### Background Art

Many studies trying to implement a super-hydrophobic surface have been performed, but most of them are performed by doing chemical treatment of a surface or building a nanostructure through semiconductor processing using a silicon wafer.

Fabrication method of a pattern with super-hydrophobic surface was disclosed in the Korean Patent Application Publication, No. 10-2010-0008579 (hereinafter, referred to "prior art").

Fabrication method of a pattern with super-hydrophobic surface according to the prior art comprise, as disclosed in the Publication, (a) forming micro-lens array with a plurality of micro-lenses uniformly arranged using photolithography process; and (b) forming micro-bowl array with a plurality of micro-bowls of complementary shape to the micro-lens uniformly arranged, using the micro-lens array as a mold.

However, making the pattern by using conventional semiconductor process, such as etching process etc., as described in the prior art has the problem that a series of processes from applying to removing photoresist has to be repeated at least more than three times.

### [Citation List]

### [Patent Literature]

Reference 1: Korean Patent Application Publication, No. 10-2010-0008579 (Jan. 16, 2010 published; Title, A pattern having a surface of super-hydrophobic and super-water repellent properties, and a fabrication method thereof; Claims 13 to 21).

CN 101 157 767 A discloses a super-hydrophobic polystyrene thin film and a preparation method thereof.

XUE-MEI LI ET AL: "What do we need for a superhydrophobic surface? A review on the recent progress in the preparation of superhydrophobic surfaces", CHEMICAL SOCIETY REVIEWS, CHEMICAL SOCIETY, LONDON, GB, vol. 36, no. 8, 1 January 2007 (2007-01-01), pages 1350-1368, XP002667653, ISSN: 0306-0012, DOI: 10.1039/B602486F [retrieved on 2007-01-31] focuses on the progress in the preparation, theoretical modeling, and applications of superhydrophobic surfaces.

CN 101 537 682 A discloses a method for preparing a polymer superhydrophobic surface by using nano-particles for assisting micromolding.

US 2007/231542 A1 discloses an article comprising a surface portion having a wettability sufficient to generate, with a reference fluid, a static contact angle of greater than about 120 degrees and a total transmission of at least about 70% in the visible range of electromagnetic radiation.

WO 2010/138132 A1 discloses methods for making microstructured flexible molds, for example useful for making microstructured metal objects in a casting process.

US 2008/318170 A1 discloses a method of making an optical disc, in which, a flexible imprint mold is made from a fluid-state flexible silicone and has a reversal pattern of a first pattern on a surface.

WO 2012/087352 A2 discloses devices, systems and techniques for producing and implementing articles and materials having nanoscale and microscale structures that exhibit superhydrophobic, superoleophobic or omniphobic surface properties and other enhanced properties.

### Disclosure

### Technical Problem

The invention is therefore directed to solving the above mentioned problem. The object of the invention is to provide a method for fabricating super-hydrophobic film sheet with a super-hydrophobic surface, comprising creating a structure with protrusion having super-hydrophobic effect like a lotus leaf by controlling the period of time and the number of times for baking photoresist; and coating on it PDMS which is polymer of optically transparent material with hydrophobic property.

### Technical Solution

This object is according to a first aspect of the invention achieved by a method according to claim 1.

### Advantageous Effects

According to the invention, a super-hydrophobic film sheet with a super-hydrophobic surface could be fabricated by creating a structure with protrusion having super-hydrophobic effect like a lotus leaf and coating on it PDMS which is polymer of optically transparent material with hydrophobic property.

Also, according to the invention, the time and cost for the fabrication could be reduced by modulating the curing time to be shorter than in the conventional method of fabrication.

Further, according to the invention, the super-hydrophobic film sheet with a super-hydrophobic like a lotus leaf could be applied to a side mirror of a vehicle. When applied to the side mirror, in case of rain, the super-hydrophobic film sheet could prevent beads of raindrop from being formed on it, thus resulting in self-cleaning effect.

### Description of Drawings

FIG. 1 shows the flow chart of the method for fabrication of super-hydrophobic film sheet according to the invention;
FIG. 2 illustrates the difference in rapidness of curing in a hot plate and an oven;
FIG. 3 illustrates a structure built by a conventional fabrication method and a structure built by the fabrication method according to this invention;
FIG. 4 shows images of protrusion in the super-hydrophobic film sheet by an optical microscope;
FIG. 5 shows images of protrusion in the super-hydrophobic film sheet by a scanning electron microscope;
FIG. 6 shows image comparison in case of existence and nonexistence of the protrusion according to this invention.

### <Description of the Reference Numerals in the Drawings>

10: silicon wafer 20: photoresist
30: PDMS

### Best Mode

Specific features and advantages will become clearer by the following description, referring to the drawings attached. It is noted that detailed descriptions of well-known devices and their functions related to this invention are omitted so as not to obscure the description of this invention with unnecessary detail.

Hereinafter detailed descriptions of the invention are set forth, referring to the drawings attached.

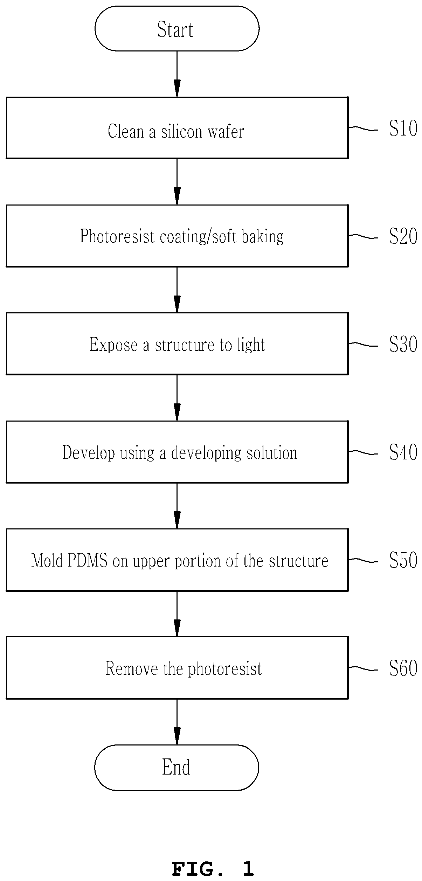

Super-hydrophobic film sheet and the fabrication method thereof according to this invention are explained as follows, referring to the FIGS. 1 to 6.

FIG. 1 shows the flow chart of the method for fabrication of super-hydrophobic film sheet. As showed, the surface of a silicon wafer is cleaned (S10).

Here the surface of the silicon wafer may be cleaned using Piranha solution RCA1, or RCA2. Then the top of the silicon wafer (10) is coated with photoresist (photo sensitizer) (AZ4620) (20) using a spin coater, and subjected to soft-baking (S20).

Specifically, the photoresist (AZ4620) (20) is coated at 3000rpm for 3s using the spin coater, and cured in an oven. This coating and baking process is performed three times.

Here at the first and second time it is cured for 5 min at 90°C in the oven, and at third time for 28 min at 90°C. Thus three times of layer coating leads to 60µm of thickness of the layer (20 µm per one time).

This soft-baking process may be performed differently using a hot plate or an oven.

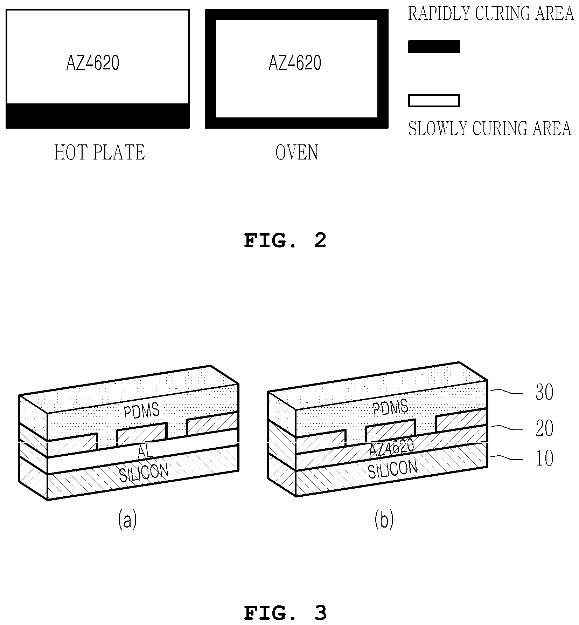

As showed in FIG. 2, in case that the process is performed using the hot plate (90°C), the curing is begun from the bottom side due to mechanical properties. However in case of use of the oven (90°C), the curing is begun rapidly from the outer side and the inside is slowly cured.

The fabrication method according to this invention uses the oven in the step (20), and a structure having a shape of protrusion is formed using the properties of being cured in the oven.

The process using the hot plate (90°C) brings a round shape in the end portion, while the process using the oven results in a protrusion shape because the inside is not completely cured even after three times of baking steps, which influences the exposing step and the developing step.

Thus, as described in the above, the peculiar structure of protrusion shape can be formed by controlling the period of time and the times of the curing of the photoresist.

Then the structure made in the step S20 is subjected to exposing using mask aligner (S30) and developed for 25 min using photoresist developer (AZ400K) (S40).

Subsequently, the upper side of the structure made through the step S40 is molded (S50).

Specifically, it is coated with PDMS (30), polymer of transparent material, at 1000rpm for 40s using the spin coater, and then is subjected to soft-baking using a vacuum oven. This coating and baking process is performed three times.

Here at the first and second time it is cured for 15 min in the vacuum oven, and at third time for 2 hours in the vacuum oven.

The PDMS can be easily introduced inside the structure since vacuum state is maintained by the vacuum oven as stated in the above.

Finally, the photoresist (AZ4620) is removed using acetone and the super-hydrophobic film sheet with nanostructure as depicted in FIG. 3 is completed (S60). FIG. 3(a) shows a structure made by conventional fabrication method.

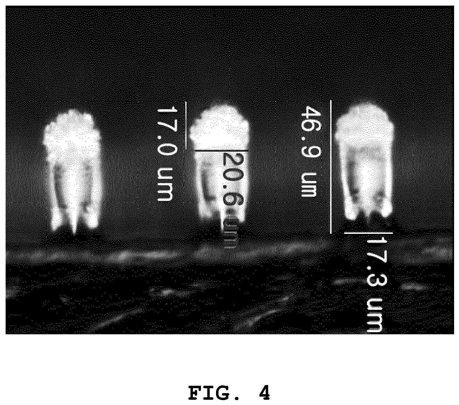

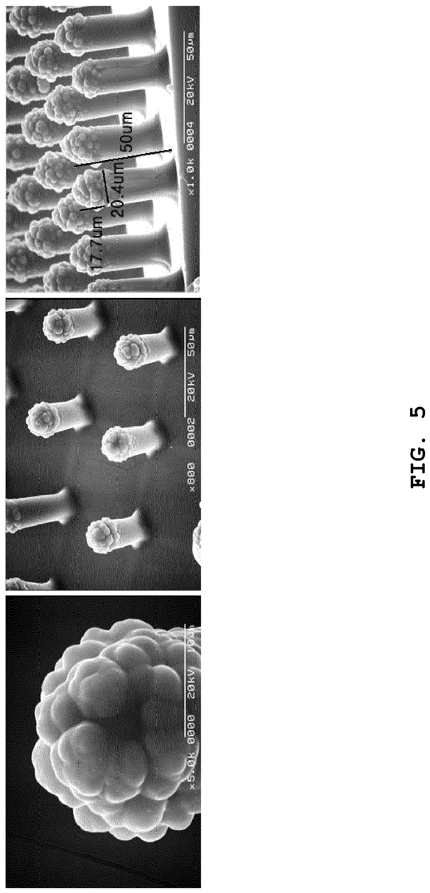

As illustrated in FIGS. 4 and 5, the pattern of the super-hydrophobic film sheet has the similar structure to a lotus leaf. Also showed by the optical microscopic image (FIG. 4) and the scanning electron microscopic (SEM) image (FIG. 5), the protrusion of pine cone shape is formed at the end portion of the structure of 50µm height, bringing a super-hydrophobic effect like the lotus leaf.

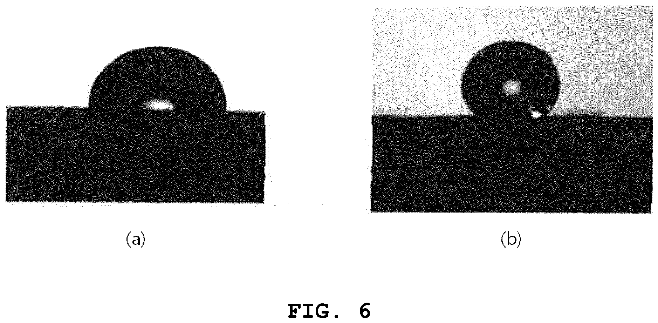

FIG. 6 shows image comparison in case of existence and nonexistence of the protrusion according to this invention. FIG. 6(a) shows the contact angle image in case that no protrusion exists, and FIG. 6(b) the contact angle image in case that the protrusion exists. As illustrated in the drawing, it shows that a superior contact angle could be made and the contact angle of 140° was measured.

While the invention has been described in connection with what is presently considered to be most practical and preferred embodiments, it is to be understood the invention is not to be limited to the disclosed embodiments, but on the contrary, is intended to cover various modifications and equivalents as defined by the appended claims.

## Claims

1. A method for fabrication of super-hydrophobic film sheet, comprising the steps of:
(a) cleaning a surface of a silicon wafer (10);
(b) coating the surface of the silicon wafer (10) with photoresist (20) using a spin coater, then soft-baking it;
(c) exposing the structure made by step (b) using a mask aligner;
(d) developing using photoresist developer;
(e) perform PDMS (30) molding over the upper side of the structure made by the step (d); and
(f) removing the photoresist (20) using acetone to complete the super-hydrophobic film sheet,
wherein the coating and soft-baking in the step (b) is performed three times using an oven, with different period of curing on each soft-baking, to make the thickness of photoresist (20) higher and to make an end portion of photoresist (20) first cured,
wherein PDMS (30) in the step (e) is coated over the upper side of the structure made by the step (d) using the spin coater and soft-baking of PDMS (30) is performed three times using a vacuum oven, with different period of time for curing on each soft-baking,
and wherein the period of time of the curing is controlled so that the inside of the photoresist (20) is not completely cured even after the three times of soft-baking is performed.

2. The method for fabrication of super-hydrophobic film sheet of claim 1, wherein the step (a) of cleaning is performed using any one among Prianha solution, RCA 1 and RCA 2.

3. The method for fabrication of super-hydrophobic film sheet of claim 1, the PDMS (30) is introduced into the structure in a vacuum.

4. The method for fabrication of super-hydrophobic film sheet of claim 1, wherein during step (b) the first and the second time the photoresist (20) is cured for 5 min at 90°C in the oven and a third time for 28 min at 90°C.

5. The method for fabrication of super-hydrophobic film sheet of claim 1, wherein PDMS (30) in the step (e) is coated over the upper side of the structure made by the step (d) using the spin coater at 1000 rpm for 40 s and soft-baking of PDMS (30) is performed three times using a vacuum oven and wherein the PDMS (30) is cured at a first and second time for 15 min in the vacuum oven and a third time for 2 h in the vacuum oven.

## Patentansprüche

1. Verfahren zur Herstellung einer superhydrophoben Folienbahn, umfassend die Schritte:
(a) Reinigen der Fläche eines Silicium-Wafers (10);
(b) Beschichten der Fläche des Silicium-Wafers (10) mit einem Photoresist (20) unter Verwendung eines Schleuderbeschichters, dann Weichbrennen desselben;
(c) Belichten der durch Schritt (b) hergestellten Struktur unter Verwendung eines Maskenausrichters;
(d) Entwickeln unter Verwendung eines Photoresist-Entwicklers;
(e) Vornehmen eines PDMS (30)-Formens über der oberen Seite der durch Schritt (d) hergestellten Struktur; und
(f) Entfernen des Photoresists (20) unter Verwendung von Aceton, um die superhydrophobe Folienbahn fertigzustellen;
wobei das Beschichten und Weichbrennen in Schritt (b) dreimal unter Verwendung eines Ofens mit einer unterschiedlichen Periode des Härtens bei jedem Weichbrennen vorgenommen wird, um die Dicke des Photoresists (20) höher zu machen und um einen Endabschnitt des Photoresists (20) zuerst gehärtet zu machen,
wobei PDMS (30) in Schritt (e) über die obere Seite der durch Schritt (d) hergestellten Struktur unter Verwendung des Schleuderbeschichters beschichtet wird, und das Weichbrennen von PDMS (30) dreimal unter Verwendung eines Vakuumofens mit einer unterschiedlichen Zeitperiode zum Härten bei jedem Weichbrennen vorgenommen wird,
und wobei die Zeitperiode des Härtens derart gesteuert wird, dass die Innenseite des Photoresists (20) nicht vollständig gehärtet wird, sogar nachdem das Weichbrennen dreimal vorgenommen wird.

2. Verfahren zur Herstellung einer superhydrophoben Folienbahn nach Anspruch 1, wobei Schritt (a) des Reinigens unter Verwendung irgendeines von einer Piranha-Lösung, RCA1 und RCA 2 vorgenommen wird.

3. Verfahren zur Herstellung einer superhydrophoben Folienbahn nach Anspruch 1, wobei das PDMS (30) in die Struktur in einem Vakuum eingebracht wird.

4. Verfahren zur Herstellung einer superhydrophoben Folienbahn nach Anspruch 1, wobei während Schritt (b) das erste und das zweite Mal das Photoresist (20) für 5 min bei 90°C in dem Ofen und ein drittes Mal für 28 min bei 90°C gehärtet wird.

5. Verfahren zur Herstellung einer superhydrophoben Folienbahn nach Anspruch 1, wobei das PDMS (30) in Schritt (e) über die obere Seite der durch Schritt (d) hergestellten Struktur unter Verwendung des Schleuderbeschichters bei 1000 UpM für 40 s beschichtet wird, und ein Weichbrennen von PDMS (30) dreimal unter Verwendung eines Vakuumofens vorgenommen wird, und wobei das PDMS (30) zu einer ersten und zweiten Zeit für 15 min in dem Vakuumofen und ein drittes Mal für 2 h in dem Vakuumofen gehärtet wird.

## Revendications

1. Procédé destiné à la fabrication de feuilles de film superhydrophobe, comprenant les étapes consistant à :
(a) nettoyer une surface d'une tranche de silicium (10) ;
(b) recouvrir la surface de la tranche de silicium (10) avec une résine photosensible (20) en utilisant une tournette, et ensuite la soumettre à une cuisson de déshydratation ;
(c) exposer la structure préparée lors de l'étape (b) en utilisant un aligneur de masque ;
(d) développer à l'aide d'un développeur de résine photosensible ;
(e) effectuer un moulage de PDMS (30) sur le côté supérieur de la structure préparée dans l'étape (d) ; et
(f) éliminer la résine photosensible (20) en utilisant de l'acétone pour obtenir la feuille de film superhydrophobe,
dans lequel le revêtement et la cuisson par déshydratation de l'étape (b) sont effectués trois fois par le biais d'un four, avec différentes périodes de durcissement pour chaque cuisson par déshydratation, pour rendre plus importante l'épaisseur de la résine photosensible (20) et pour permettre à une portion d'extrémité de résine photosensible (20) de durcir en premier,
dans lequel le PDMS (30) dans l'étape (e) est revêtu sur le côté supérieur de la structure préparée dans l'étape (d) par le biais de la tournette et la cuisson par déshydratation du PDMS (30) est effectuée trois fois par le biais d'un four à vide, avec une différente période de temps pour le durcissement sur charque cuisson par déshydratation,
et dans lequel la période de temps du durcissement est commandée de telle sorte que l'intérieur de la résine photosensible (20) n'est pas complètement durci même après que la cuisson par déshydratation soit effectuée trois fois.

2. Procédé destiné à la fabrication d'une feuille de film superhydrophobe selon la revendication 1, dans lequel l'étape (a) de nettoyage est effectué en utilisant l'un parmi la solution de Prianha, le RCA 1 et le RCA 2.

3. Procédé destiné à la fabrication d'une feuille de film superhydrophobe selon la revendication 1, dans lequel le PDMS (30) est introduit au sein de la structure sous vide.

4. Procédé destiné à la fabrication d'une feuille de film superhydrophobe selon la revendication 1, dans lequel pendant l'étape (b) la première et la deuxième fois, la résine photosensible (20) est durcie pendant 5 minutes à 90 °C dans le four et une troisième fois pendant 28 minutes à 90 °C.

5. Procédé destiné à la fabrication d'une feuille de film superhydrophobe selon la revendication 1, dans lequel le PDMS (30) dans l'étape (e) est recouvert sur le côté supérieur de la structure préparée lors de l'étape (d) en utilisant la tournette à 1000 rpm pendant 40 secondes et la cuisson par déshydratation du PDMS (30) est effectuée par trois fois en utilisant un four à vide et dans lequel le TDM S (30) est durci les première et deuxième fois pendant 15 minutes dans le four à vide et une troisième fois pendant 2 heures dans le four à vide.
